# EUROPEAN PATENT APPLICATION

(11) **EP 4 455 681 A1**
(43) Date of publication of application: **30.10.2024**
(21) Application number: 22909927.0
(22) Date of filing: 19.12.2022
(51) Int. Cl.: G01Q 70/08

(54) **PROBE APPARATUS AND PROBE CONTROL DEVICE**

(30) Priority: 20.12.2021 CN 202111563769
(71) Applicant: Parcan NanoTech Co., Ltd, Shanghai 201821 (CN)
(72) Inventor: ZHOU, Xiangqian, Shanghai 201821 (CN); RANGELOW, Ivo, 34225 Baunatal (DE)
(74) Representative: Viering, Jentschura & Partner mbB Patent- und Rechtsanwälte
(86) International application number: PCT/CN2022/139957
(87) International publication number: WO 2023/116614

(57) **Abstract**

Embodiments of the present application provide a probe device and a probe control apparatus, relating to the field of control technology. The probe device comprising: a functional layer, a plurality of probes, and at least one signal processing unit; the plurality of probes are provided on one surface of the functional layer, and the at least one signal processing unit is provided on the other surface of the functional layer; each signal processing unit corresponds to at least one probe, and each probe corresponds to and is electrically connected to one signal processing unit; the signal processing unit is used to generate a probe control signal according to control parameters input by a user and send the probe control signal to the corresponding probe; the probe is used to operate and process the surface to be operated according to the received probe control signal and send the obtained probe data signal to the corresponding signal processing unit. In the present application, a three-dimensional structure probe device comprising signal processing units and probes is formed.

## Description

### Cross-references to related applications

This patent application claims priority to Chinese patent application No. 2021115637690, filed on December 20, 2021, and entitled "Probe device and probe control apparatus", the text of which is incorporated herein by reference.

### Technical field

The present application relates to the field of control technology, and specifically to a probe device and a probe control apparatus.

### Background

In the chip industry, the miniaturization of chip devices has been an important research direction, the manufacture of 5-nanometer technology node of the chip has been achieved, and the manufacture of 3-nanometer technology node of the chip has been successfully developed, however, the chip industry's measurement technology is far behind. Not only are the detection means insufficient, but also reach the nanometer surface measurement is often very slow, cannot meet the chip industry online inspection, or even sampling level.

Existing optical ellipsometry detection technology can detect the three-dimensional structure of the wafer surface with a longitudinal resolution of less than 1 nm and is fast enough to be used for on-line inspection, but the lateral resolution is still in the submicron order of magnitude, which is not able to satisfy the requirement of measurement resolution.

Scanning Probe Microscope (SPM) can measure sub-nanometer longitudinal and lateral resolution, especially 3D structures from a few nanometers to tens of nanometers. However, its measurement speed is slow, and it has been estimated that a complete measurement of a die on a wafer (DIE) takes at least 30 days. One of the main reasons for the slow measurement speed is that the probe must be only a few nanometers to a few tens of nanometers away from the surface to measure nanoscale 3D morphology. To avoid collisions between the probe and the 3D structure of the surface to be measured, which would affect the accuracy of the measurement, the probe must travel at an extremely slow speed during the measurement process.

Physical quantities such as surface conductivity, surface photoresist residue, distribution of different components on the surface, etc. can be measured using probe technology.

Needle tips are extremely thin, with a radius of curvature of only 2 nanometers, or even just one atom at the tip. Adding a very small voltage to the probe, for example 50V, can cause the tip of the probe to have a very high electric field strength. At this point, the electrons at the tip are easily pulled out, creating an electric field emission from the tip of the probe. The use of the needle tip formed by the electric field emission of electrons can be photoresist sensitized to form an electron beam lithography, also known as scanning probe lithography (SPL).

The advantage of scanning probe lithography is that the lithographic lines are very fine, making it ideal for exposing single nanometer fine line structures. In addition to the very small needle tip emitting electrons to form a single nanometer electron beam spot, the reason is that the energy of the emitted electrons is so low that it is difficult to form a major problem of electron beam lithography, i.e., the proximity effect. Due to the absence of the neighborhood effect, the broadening of the light-sensitive zone after exposure to the electron beam is no longer a problem, so that the size of the probe electron beam directly determines the photoresist light-sensitive area, forming a single nanometer lithographic line width.

However, the problem with probe-tip e-beam lithography is that the needle tip of the probe needs to be moved one point at a time, with an e-beam exposure at each point. The moving speed of the needle tip is much slower than the electron beam scanning speed of conventional electron beam lithography, making the tip lithography speed very low and unable to complete a large area of lithography in a limited time.

The three-dimensional topographic measurement, the conductivity measurement, and the electron emission of the probe can be referred to as the operation of the probe on the target surface. Currently, it is possible to increase the speed by setting up a multi-probe array so that a plurality of probes can perform a measurement operation or a photolithography operation at the same time.

However, improving the speed of operation of probe arrays is not just the problem of probes needing to be measured quickly, and being accelerated by multiple probes, but the problem of enabling the massive amount of signals measured to be transmitted and processed in parallel, i.e., the problem of how to lead out the multi-probe signals with a finite number of leads, and the problem of processing the signals of a large number of parallel probes in parallel.

One of the ways to deal with multi-lead parallel signals is to use a data bus to greatly reduce the number of leads by multiplexing a huge number of leads. However, if the number of probes is huge, the way of only using multiplexing will greatly reduce the signal processing time, resulting in a reduction of signal processing speed to meet the demand for processing speed.

As can be seen from the above, high speed is required both in the utilization of parallel probe arrays for sample surface measurement, electron field emission, and guided ion implantation, and how to integrate the numerous probe arrays in parallel with the subsequent signal unit to form parallel measurement and signal processing is the key to improving the measurement speed. Therefore, to solve the above technical problems, the inventor proposes the technical solution of the present application.

### Summary of the invention

It is an object of the present application to provide a probe device and a probe control apparatus, thus forming a three-dimensional structured probe device comprising a signal processing unit and a probe, reducing the connecting wires between the signal processing unit and the probe, and at the same time, a plurality of probes and the signal processing unit are integrated on different surfaces of the same functional layer, which reduces the influence of heat emitted by the signal processing unit on the probe, and reduces the loss of accuracy.

To achieve the above purpose, the present application provides a probe device comprising: a functional layer, a plurality of probes, and at least one signal processing unit; said plurality of probes are provided on one surface of said functional layer and said at least one signal processing unit is provided on the other surface of said functional layer; each said signal processing unit corresponds to at least one said probe, and each said probe corresponds to and is electrically connected to one said signal processing unit; said signal processing unit is used to generate a probe control signal according to control parameters input by a user and send said probe control signal to the corresponding probe; said probe is used to operate and process a surface to be operated according to said probe control signal received, and to send probe data signals obtained to the corresponding signal processing unit.

The present application also provides a probe device comprising: a plurality of functional layers fixed in a non-contact manner, a plurality of probes, and a plurality of signal processing units; said plurality of functional layers comprise a probe layer and M data processing layers stacked sequentially from bottom to top; said plurality of probes are provided on a surface of said probe layer away from said data processing layers, and said plurality of signal processing units are provided on said data processing layers, respectively, and M is an integer greater than or equal to 1; each said signal processing unit on a first said data processing layer corresponds to at least one said probe, and each said probe corresponds to and is electrically connected to one said signal processing unit located on the first said data processing layer; said signal processing unit on a Nth said data processing layer of M said data processing layers corresponds to at least one said signal processing unit on a N-1th said data processing layer, and said signal processing unit on the Nth said data processing layer corresponds to and is electrically connected to one said signal processing unit on a N+1th said data processing layer, wherein 1≤N≤M, and N is an integer; said probe device is used to receive input control parameters through said signal processing unit on at least one said data processing layer and generate probe control signals for said probes ; said probe device is used to send said probe control signals to the corresponding probes via said signal processing unit on a first said data processing layer; said probe is used to operate and process a surface to be operated according to said probe control signals received, and to send probe data signals obtained to the corresponding signal processing unit.

The present application also provides a probe control apparatus comprising: a probe device as described above, and a probe control system connected to the probe device.

In an embodiment of the present application, a probe device comprises: a functional layer, a plurality of probes, and at least one signal processing unit, the plurality of probes is disposed on one surface of said functional layer, and said at least one signal processing unit is disposed on the other surface of said functional layer; each said signal processing units corresponds to at least one said probe, and each said probes corresponds to and is electrically connected to one said signal processing units, the signal processing unit is capable of generating a probe control signal according to a control parameter input by a user and sending said probe control signal to the corresponding probe, the probes are capable of operating the surface to be operated according to said probe control signal received, and sending probe data signals obtained to the corresponding signal processing unit; thereby forming a three-dimensional structural probe device comprising the signal processing unit and the probe, which reduces the connecting wires between the signal processing unit and the probe, while a plurality of probes and the signal processing unit are integrated on different surfaces of the same functional layer, which reduces the influence of heat emitted from the signal processing unit on the probe and reduces the loss of precision.

In one embodiment, M≥2, said signal processing unit on the first said data processing layer sends said probe data signals to the signal processing unit on a M-th said data processing layer upon receiving the probe data signals sent by the corresponding probes; after receiving said probe data signals from said probes, said signal processing unit on the M-th said data processing layer processes said probe data signals to obtain a data processing result of the surface to be operated.

In one embodiment, M≥2, upon receiving a probe data signal sent by a corresponding said probe, said signal processing unit on the first said data processing layer of M said data processing layers processes the probe data signals of the corresponding probes, obtains data processing results of the corresponding probes and sends said data processing results of said probes to the signal processing unit on a M-th said data processing layer; said signal processing unit on the M-th said data processing layer obtains a data processing result of the surface to be operated based on the data processing results of said probes upon receiving the data processing results of said probes.

In one embodiment, the probe data signals of said probes are stored in the corresponding signal processing unit on the first said data processing layer, or stored in the corresponding signal processing unit on the M-th said data processing layer.

In one embodiment, said functional layer is provided with a plurality of through-holes, which are provided with insulating layers on inner walls, said through-holes are provided with conductive substances, and each said signal processing unit corresponds to at least one said through-hole, and each said through-hole corresponds to one said signal processing unit; said signal processing unit is electrically connected to a target probe through the conductive substances in the corresponding through-holes; and said target probe is said probe corresponding to the said signal processing unit.

In one embodiment, said functional layer is provided with a plurality of through-holes, said through-holes are provided with insulating layers on inner walls, each said signal processing unit corresponds to at least one said through-hole, and each said through-hole corresponds to one said signal processing unit; said signal processing unit is electrically connected to a target probe by means of leads passing through the corresponding through-holes, and said target probe is said signal processing unit corresponding to said probe.

In one embodiment, said probes comprise: a needle, a cantilever beam, and a tip, and in each of said probes, said tip is provided at a tip portion of said needle, said needle is fixed to an end of said cantilever beam, and one end of said cantilever beam away from said needle, comprises: a control input terminal and a signal output terminal; said signal processing unit comprises a control output terminal and a signal input terminal, and said control input terminal of said cantilever beam is connected to the corresponding control output terminal of said signal processing unit, and the signal output terminal of said cantilever beam connected to the corresponding signal input terminal of said signal processing unit; said probe is used to control said needle tip to operate the surface to be operated according to said probe control signal received from said control input terminal, and to send the obtained probe data signal to the signal input terminal of said signal processing unit connected thereto.

In one embodiment, said functional layer is any of the following: a silicon wafer, a glass wafer, a quartz wafer, a wafer, or a printed circuit board.

In one embodiment, a heat dissipation layer is provided between two adjacent said functional layers.

In one embodiment, said heat dissipation layer is a semiconductor cooling layer.

In one embodiment, each said data processing layer is provided with a plurality of through-holes, which are provided with insulating layers on inner walls, and said through-holes are provided with conductive substances, and on each said data processing layer, each said signal processing unit corresponds to at least one said through-hole, and each said through-hole corresponds to one said signal processing unit; when 1≤N<M, for each said signal processing unit on a Nth said data processing layer of the M said data processing layers, said signal processing unit is electrically connected to a target signal processing unit in the N+1th said data processing layer by means of conductive materials in the corresponding through-holes; said target signal processing unit is a signal processing unit corresponding to said signal processing unit on a N+1th said data processing layer signal processing unit; When N=1, for each said signal processing unit on the first said data processing layer of the M said data processing layers, said signal processing unit is electrically connected to a target probe on said probe layer by means of the conductive substances in the corresponding through-holes; said target probe is said probe corresponding to said signal processing unit.

In one embodiment, said functional layer is provided with a plurality of through-holes, which are provided with insulating layers on inner walls, and on each said data processing layer, each said signal processing unit corresponds to at least one said through-hole, and each said through-hole corresponds to one said signal processing unit; when 1≤N<M, for each said signal processing unit on a Nth said data processing layer of the M said data processing layers, said signal processing unit is electrically connected to a target signal processing unit in a N+1th said data processing layer by means of leads passing through the corresponding through-holes; said target signal processing unit is a signal processing unit on the N+1th said data processing layer corresponding to said signal processing unit; when N=1, for each said signal processing unit on the first said data processing layer of the M said data processing layers, said signal processing unit is electrically connected to a target probe on said probe layer by means of leads passing through the corresponding through-holes; said target probe is said probe corresponding to said signal processing unit.

In one embodiment, said probe layer is provided with a plurality of positioning marks, and each said data processing layer is provided with a plurality of positioning holes, said positioning holes are corresponding one-to-one with said positioning marks, and positions of said positioning holes on each said data processing layer and those of the corresponding positioning marks on said probe layer correspond in vertical space. In this way, the probe layer and the data processing layers are spatially aligned with each other.

In one embodiment, a plurality of pairs of matched raised portions and recessed portions are provided on opposite faces between two adjacent functional layers, respectively; positions of each pair of matched said raised portions and said recessed portions correspond in vertical space. In this way, the probe layer and the data processing layers are spatially aligned with each other.

In one embodiment, said probe comprises: said probe comprises: a probe head, a cantilever beam and a needle tip, in each said probe, said needle tip is provided at a tip portion of said probe head, said probe head is fixed to one end of said cantilever beam, one end of said cantilever beam away from said probe head comprises: a control input terminal and a signal output terminal; and each said signal processing unit comprises a signal receiving terminal, a signal transmitting terminal, a control output terminal and a signal input terminal, said control input terminal of said cantilever beam is connected to the control output terminal of the corresponding signal processing unit in a first said data processing layer, said signal output terminal of said cantilever beam is connected to the signal input terminal of the corresponding signal processing unit in a first said data processing layer; in a Nth said data processing layer of M said data processing layers, the signal transmitting terminal of said signal processing unit is connected to the signal input terminal of the corresponding signal processing unit in a N+1th said data processing layer, and the signal receiving terminal of said signal processing unit is connected to the control output terminal of the corresponding said signal processing unit in the N+1th said data processing layer; said probe is used to control said needle tip to operate and process the surface to be operated according to said probe control signal received from said control input terminal, and to send an obtained probe data signal to the signal input terminal of said signal processing unit connected thereto; said signal processing unit is used to send the received probe data signal to the corresponding signal processing unit in a target functional layer; said target functional layer is said data processing layer previous to said data processing layer in which said signal processing unit is located.

In one embodiment, said functional layer is any of the following: a silicon wafer, a glass wafer, a quartz wafer, a wafer, or a printed circuit board.

In one embodiment, each said probe has a corresponding address and any two said probes correspond to different addresses.

### BRIEF DESCRIPTION OF THE DRAWINGS

Fig. 1 and 2 are schematic diagrams of a probe device according to a first embodiment of the present application;
Fig. 3 and 4 are schematic diagrams of a signal processing unit electrically connected to a probe in a probe device according to a first embodiment of the present application;
Fig. 5 and 6 are schematic diagrams of a signal processing unit electrically connected to a probe via a through-hole on a functional layer in a probe device according to a first embodiment of the present application;
Fig. 7 is a schematic diagram of a probe layout on a probe layer of a probe device according to a first embodiment of the present application;
Fig. 8 to 12 are schematic diagrams of a probe device according to a second embodiment of the present application;
Fig. 13 is a schematic diagram of a signal processing unit connected via a bus between two adjacent data processing layers according to a second embodiment of the present application;
Fig. 14 and Fig. 15 are schematic diagrams of providing positioning holes on the data processing layer with positioning marks on the probe layer, according to a second embodiment of the present application;
Fig. 16 to 18 are schematic diagrams of a plurality of pairs of matched raised portions and recessed portions provided on opposite surfaces between two adjacent functional layers in a probe device, respectively, according to a second embodiment of the present application;
Fig. 19 is a schematic diagram of a signal processing unit electrically connected between two adjacent data processing layers via a through-hole on the data processing layer in a probe device according to a second embodiment of the present application.

### Detailed embodiments

Each embodiment of the present application will be described in detail hereinafter in conjunction with the accompanying drawings for a clearer understanding of the purposes, features and advantages of the present application. It should be understood that the embodiments shown in the accompanying drawings are not intended to be a limitation of the scope of the present application but are merely intended to illustrate the substantive spirit of the technical solution of the present application.

In the following description, certain specific details are set forth for the purpose of illustrating various disclosed embodiments to provide a thorough understanding of various disclosed embodiments. However, those skilled in the relevant field will recognize that embodiments may be practiced without one or more of these specific details. In other instances, familiar devices, structures, and techniques associated with the present application may not be shown or described in detail to avoid unnecessarily confusing the description of the embodiments.

Unless the context requires otherwise, throughout the specification and the claims, the words "comprising" and variants thereof, such as "including" and "having", are to be understood as open-ended and inclusive meaning, i.e., should be interpreted as "including, but not limited to".

References to "an embodiment" or "one embodiment" throughout the specification indicate that a particular feature, structure, or characteristic described in conjunction with an embodiment is included in at least one embodiment. Therefore, the occurrence of "in an embodiment" or "in one embodiment" at various locations throughout the specification need not all refer to the same embodiment. In addition, particular features, structures or characteristics may be combined in any manner in one or more embodiments.

As used in the specification and in the appended claims, the singular forms "a", "an" and "" include plural referents, unless the context clearly provides otherwise. It should be noted that the term "or" is normally used in its inclusive sense of "or/and", unless the context clearly provides otherwise.

In the following description, in order to clearly show the structure and working method of this application, it will be described with the help of many directional words, but "front", "back", "left", "right", "outside", "inside", "outward", "inward" should be included, "right", "outside", "inside", "outward", "inward ", "up", "down", etc. are to be understood as terms of convenience and not as qualifying terms.

A first embodiment of the present application relates to a probe device, wherein the probe device is used to operate and process a surface of a wafer to be operated, and the processing on the surface of the wafer to be operated include: measurements of physical and chemical quantities on the surface of the wafer to be operated, scanning probe lithography (SPL), generation of electrons, generation of photons, and introduction of ions to the surface of the wafer to be operated by means of the probe. Ion implantation on the surface to be operated, etc. Wherein the related physical and chemical quantities include, but are not limited to: electrical information, mechanical information, magnetic information, optical information, acoustic information, and material composition, such as three-dimensional morphology measurements, surface roughness measurements, surface electrical conductivity measurements, surface composition measurements, surface temperature measurements, surface hardness measurements, surface elasticity modulus measurements, surface emission measurements, surface light emission measurements, surface Raman signal measurements, etc.; scanning probe lithography is that: the voltage (e.g., 50V) is applied to the probe, and an electric field with a high electric field strength is formed on the needle tip of the probe, at this time, the electrons on the needle tip can easily be pulled out, and forming the electric field emission of the probe head of the probe, thus using the electrons emitted by the electric field formed on the needle tip of the probe to sense the photoresist to form a e-beam lithography, the electrons emitted by the probe can generate the secondary electrons on the surface to be operated.

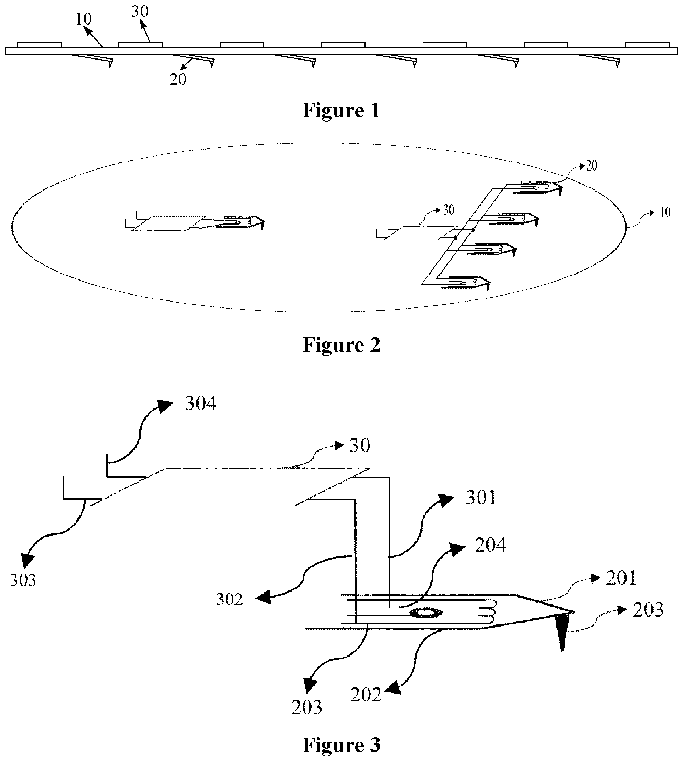

Referring to FIG. 1, the probe device includes a functional layer 10, a plurality of probes 20, and a plurality of signal processing units 30. Wherein the signal processing units 30 may have functions of data processing and data storage.

The plurality of probes 20 are provided on one surface of the functional layer 10, and the at least one signal processing unit 30 is provided on the other surface of the functional layer 10; each signal processing unit 30 corresponds to at least one probe 20, and each probe 20 corresponds to and is electrically connected to one signal processing unit 30. Specifically, a plurality of probes 20 and a plurality of signal processing units 30 are provided on two surfaces of the functional layer 10 respectively, each signal processing unit 30 corresponds to one or more probes 20, each probe 20 only corresponds to one signal processing unit 30, and the probes 20 are electrically connected to the corresponding signal processing unit 30 respectively. Wherein, it is possible to provide that the signal processing units 30 correspond to the same number of probes 20 and electrically connected to the corresponding probes 20, or the signal processing units 30 correspond to a different number of probes 20 respectively and are electrically connected to the corresponding probes 20. As shown in FIG. 2, one of the signal processing units 30 is electrically connected to one probe 20, and another signal processing unit 30 is electrically connected to four probes 20; in the figure, the functional layer 10 is a transparent layer, the actual functional layer 10 is an opaque layer, and the signal processing unit 30 and the probes 20 are located on the upper and lower surfaces of the functional layer 10, respectively.

The signal processing unit 30 is used to generate probe control signals according to the control parameters input by the user and send the probe control signals to the corresponding probes 20. Specifically, the signal processing units 30 located on the same surface of the functional layer 10 are electrically connected to a probe control system respectively, the probe control system is provided for the user to input the control parameters, and sends the control parameters input by user to the signal processing units 30, the signal processing unit 30 generates probe control signals of the corresponding the probes 20 upon receiving the control parameters, and sends the probe control signals to the corresponding probes 20 to control the electrically-connected probes 20 to perform the corresponding processing of the surface of the wafer to be operated.

The probes 20 are used to operate and process the surface to be operated according to the probe control signals received, and send probe data signals obtained to the corresponding signal processing units 30. For each probe 20, its operating parameters, such as operating mode, operating range, etc., are set in the received probe control signals sent by the corresponding signal processing unit 30, and the probes 20 can operate and process the surface to be operated based on the probe control signals, obtain the probe data signals, and send the probe data signals to the signal processing units 30, and the signal processing units 30 can digitize, decode and process the received probe data signal to obtain the data of pixels of the surface to be operated, and send the data of pixels to the probe control system, and a complete image of the surface to be operated of the wafer is generated by the probe control system. Wherein, the probe data signals of the probes 20 include, but are not limited to: a longitudinal force signal of the probe, a spatial position signal of the probe, speed data of the probe, vibration frequency data of the probe, temperature data of the probe, code or address data of the probe, and the like.

In this embodiment, the functional layer 10 may be a support sheet that is micro-/ nano-processed and has a certain mechanical strength, and the functional layer 10 may be any of the following: a silicon wafer, a glass wafer, a quartz wafer, a wafer, or a printed circuit board.

It should be noted that the present embodiment and subsequent embodiments only schematically show the number of probes and the arrangement of the probes, the number of probes and the arrangement of the probes can be set in accordance with the processing requirements of the surface to be operated, for example, a plurality of probes may be arranged in a single row or in an array, and the plurality of probes may be arranged in a two-dimensional plane, or may be non-coplanar to form a three-dimensional structure.

The present embodiment provides a probe device comprising: a functional layer, a plurality of probes, and at least one signal processing unit, the plurality of probes are disposed on one surface of the functional layer, and the at least one signal processing unit is disposed on the other surface of the functional layer; each signal processing unit corresponds to at least one probe, and each probe corresponds to and is electrically connected to one signal processing unit, the signal processing unit is capable of generating probe control signals according to control parameters input by a user, and sending the probe control signals to the corresponding probes, and the probe is capable of operating and processing a surface to be operated according to the probe control signals received, and sending probe data signals obtained to the corresponding probes; thereby forming a three-dimensionally structured probe device comprising the signal processing unit and the probes, which reduces the connecting wires between the signal processing unit and the probes, and a plurality of probes and signal processing units are integrated on different surfaces of the same functional layer, which reduces the influence of heat emitted from the signal processing unit on the probes and reduces the loss of precision.

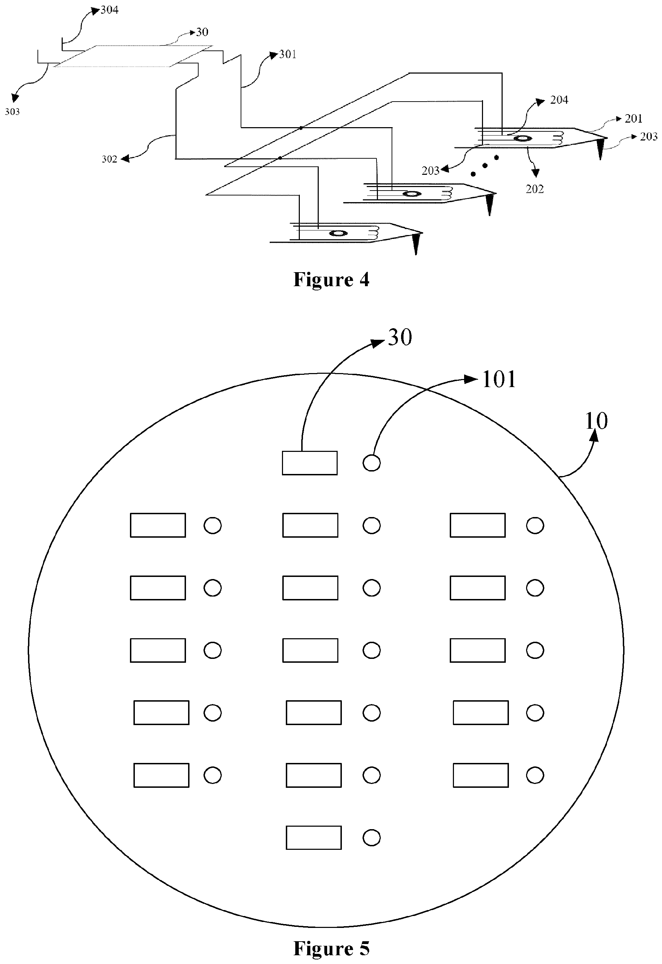

In one example, referring to FIG. 3, the probe 20 comprises: a probe head 201, a cantilever beam 202, and a needle tip 203, and in each probe 20, the needle tip 203 is provided at a tip portion of the needle 201, the needle 201 is fixed to an end of the cantilever beam 202, and one end of the cantilever beam 202 away from the needle 201 includes: a control input terminal 204 and a signal output terminal 205; the signal processing unit 30 includes a control output terminal 301 and a signal input terminal 302, the control input terminal 204 of the cantilever beam 202 is connected to the control output terminal 301 of the corresponding signal processing unit 30, and the signal output terminal 205 of the cantilever beam 202 is connected to the signal input terminal 302 of the corresponding signal processing unit 30. In addition, the signal processing unit 30 further includes a signal sending terminal 303 and a signal receiving terminal 304, the signal sending terminal 303 and the signal receiving terminal 304 are connected to the probe control system, respectively. It is to be noted that the signal processing unit 30 may also be provided with an operation information receiving terminal, which is connected to the probe control system, and the probe control system sends the operation parameters of the operation station where the probe device is located to the signal processing unit 30 via the operation information receiving terminal, so that the signal processing unit 30 can determine the wafer position, angle, speed, and other information on the basis of the operation parameters, and then generate control parameters of the probes 20 in combination with the control parameters input by the user to control the probes 20 to carry out corresponding processing on the surface of the wafer to be operated. It is to be noted that the connection between the signal processing unit 30 and one corresponding probe 20 is only schematically shown in FIG. 3. Additionally, referring to FIG. 4, when the signal processing unit 30 corresponds to a plurality of probes 20, the signal processing unit 30 and the plurality of probes 20 are connected to each other via a bus, i.e., the control output terminal 301 of the signal processing unit 30 is connected to a bus while the control input terminals 204 of the plurality of probes 20 are connected respectively to that bus; the signal input terminal 302 of the signal processing unit 30 is connected to another bus, while the signal output terminals 205 of the plurality of probes 20 are respectively connected to that bus.

The probe 20 is used to control the probe tip 203 to operate and process the surface to be operated according to the probe control signals received from the control input terminal 204, and to send probe data signals obtained to the signal input terminal 301 of the signal processing unit connected thereto.

Specifically, taking any signal processing unit 30 as an example, the signal processing unit 30 receives control parameters from the probe control system via the signal receiving terminal 304, generates probe control signals for the corresponding probes 20 based on the control parameters, and sends the probe control signals to the corresponding probes 20 via the control output terminal 301 to control the electrically-connected probes 20 to perform corresponding processing on the surface of wafer to be operated, after receiving the corresponding probe control signal via the control input terminal 204, the probes 20 control the needle tip 203 to operate and process the surface to be operated based on the probe control signals, and operate and process the surface to be operated based on the operating parameters of the probe 20 set in the probe control signals to obtain probe data signals, and send the probe data signals to the corresponding signal processing unit 30 via the signal output terminal 205, the signal processing unit 30 may directly send the received probe data signals to the probe control system via the signal transmitting terminal 303, or may pre-process the probe data signals and send the processed probe data signals to the probe control system.

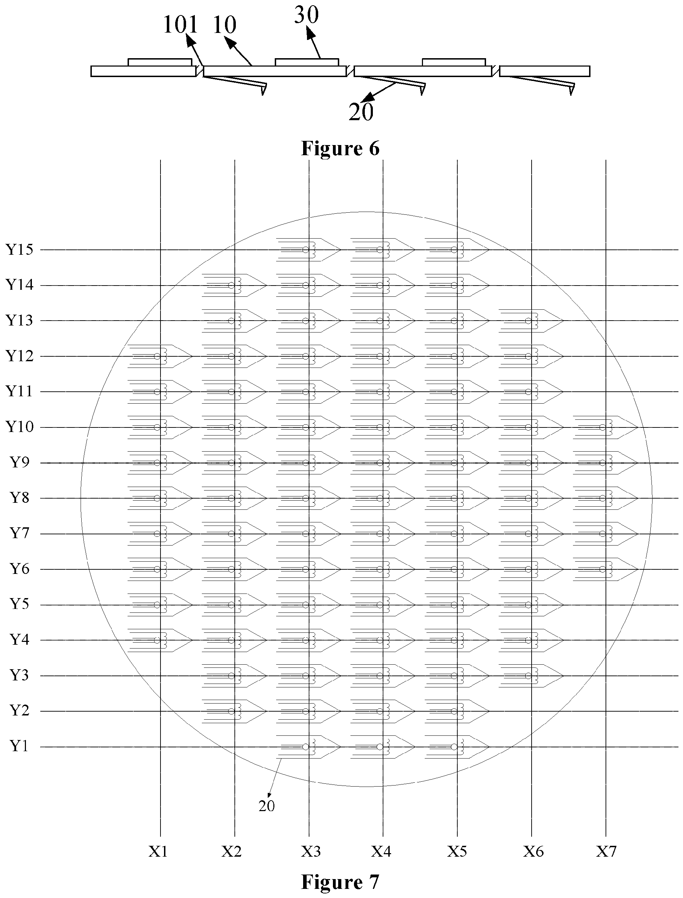

In one embodiment, referring to FIGS. 5 and 6, the functional layer 10 is provided with a plurality of through-holes 101, which are provided with insulating layers on inner walls, the through-holes 101 are provided with conductive substances (e.g., copper, silver, or other conductive material), and each signal processing unit 30 corresponds to at least one through-hole 101 (one through-hole 101 corresponding to each signal processing unit 30 is used as an example in the figures), each through-hole 101 corresponds to one signal processing unit 30; the signal processing unit 30 is electrically connected to a target probe through the conductive material in the corresponding through-hole; the target probe is the probe 20 corresponding to the signal processing unit 30. Specifically, the functional layer 10 is provided with a plurality of through-holes 101, the number of the through-holes 101 is greater than or equal to the number of the signal processing units 30, and each signal processing unit 30 may correspond to one or more through-holes 101, each through-hole 101 may only correspond to one signal processing unit 30, the through-holes 101 are filled with conductive materials, which is equivalent to forming an electrically conductive channel in the through-hole 101, and the electrically conductive channel forms an electrical connection between the two surfaces of the functional layer 10; for each signal processing unit 30, taking the signal processing unit 30 corresponding to one through-hole 101 as an example, the control output terminal 301 and the signal input terminal 302 of the signal processing unit 30 may be electrically connected via the wiring on the surface of the functional layer 10 where it is located or directly welded to the conductive channel of the through-hole 101, thereby realizing the electrical connection of the signal processing unit 30 and the corresponding probes 20, and the conductive channel is formed by filling the through-hole 101 with a conductive substance, which makes the connection more convenient.

In another embodiment, the functional layer 10 is provided with a plurality of through-holes 101, which are provided with insulating layers on inner walls, each signal processing unit 30 corresponds to at least one through-hole 101, and each through-hole 101 corresponds to one signal processing unit 30; the signal processing unit 30 is electrically connected to a target probe by means of leads passing through the corresponding through-hole 101, and the target probe is a probe 20 that corresponds to the signal processing unit 30. Specifically, the functional layer 10 is provided with a plurality of through-holes 101, the number of through-holes 101 is greater than the number of signal processing units 30, each signal processing unit 30 may correspond to one or more through-holes 101, and each through-hole 101 only corresponds to one signal processing unit 30; for each signal processing unit 30, taking the signal processing unit 30 corresponding to one through-hole 101 as an example, the control output terminal 301 and the signal input terminal 302 of the signal processing unit 30 form two connection points on the surface of the functional layer 10 where it is located, and then two conductive leads are used to connect to the two connection points respectively, and then the conductive leads pass through the through-hole 101 and then are connected to the control input terminal 204 and the signal output terminal 205 of the probe 20 that is located on the other surface of the functional layer 10, thereby realizing an electrical connection between the signal processing unit 30 and the corresponding probes 20; wherein the present embodiment can be referred to FIG. 5 and FIG. 6, the main difference being that the through-hole 101 in FIG. 6 is not filled with the conductive substance.

In one embodiment, each probe has a corresponding address, and any two probes correspond to different addresses; please refer to FIG. 7, a plurality of probes 20 are provided in the probe layer 11, and the address of each probe 20 is expressed in the coordinates of the location where it is located, for example, the addresses of nine probes 20 in the first column are from the bottom to the top: (X1, Y4), (X1, Y5), (X1, Y6), (X1. Y7), (X1, Y8), (X1, Y9), (X1, Y10), (X1, Y11), (X1, Y12); wherein the value of X, Y in the address of each probe 20 may be one or more bytes, whereby the probes 20 may be identified separately. It should be noted that the way in which the probes 20 are laid out on the probe layer 11 is only schematically shown in FIG. 7.

A second embodiment of the present application relates to a probe device, wherein the probe device is used to operate and process a surface of a wafer to be operated, and the processing on the surface of the wafer to be operated include: measurements of physical and chemical quantities on the surface of the wafer to be operated, scanning probe lithography (SPL), generation of electrons, generation of photons, and introduction of ions to the surface of the wafer to be operated by means of the probe. Ion implantation on the surface to be operated, etc. Wherein the related physical and chemical quantities include, but are not limited to: electrical information, mechanical information, magnetic information, optical information, acoustic information, and material composition, such as three-dimensional morphology measurements, surface roughness measurements, surface electrical conductivity measurements, surface composition measurements, surface temperature measurements, surface hardness measurements, surface elasticity modulus measurements, surface emission measurements, surface light emission measurements, surface Raman signal measurements, etc.; scanning probe lithography is that: the voltage (e.g., 50V) is applied to the probe, and an electric field with a high electric field strength is formed on the probe tip of the probe, at this time, the electrons on the probe tip can easily be pulled out, and forming the electric field emission of the probe head of the probe, thus using the electrons emitted by the electric field formed on the probe tip of the probe to sense the photoresist to form a e-beam lithography, the electrons emitted by the probe can generate the secondary electrons on the surface to be operated.

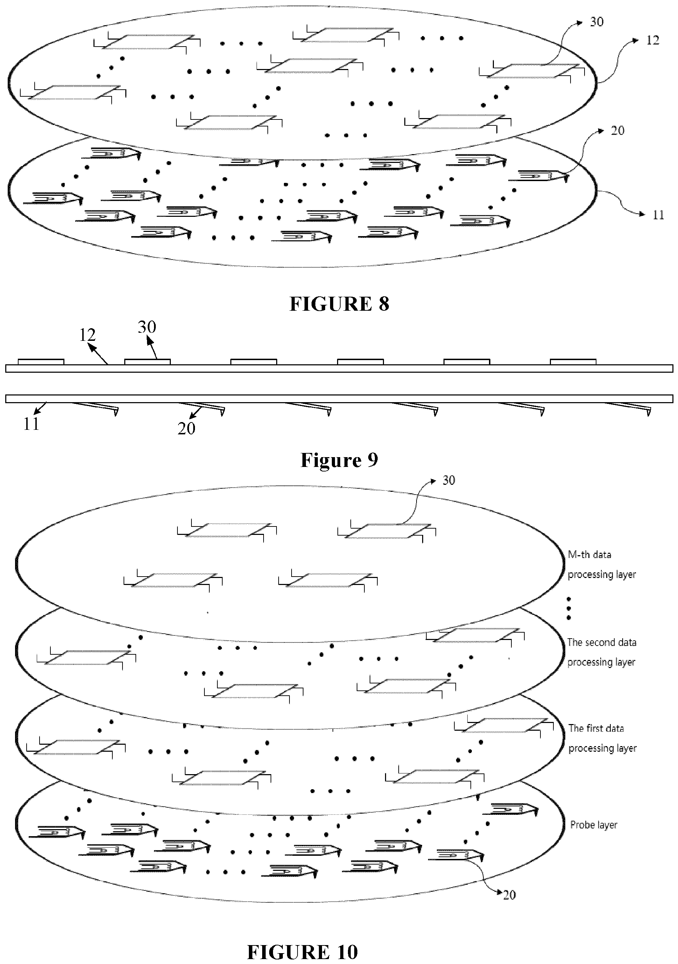

Referring to FIGS. 8 to 11, the probe device comprises: a plurality of functional layers fixed in non-contact manner, a plurality of probes 20, and a plurality of signal processing units 30. Wherein the signal processing units 30 may have functions of data processing and data storage. Wherein the fixed manner between two adjacent functional layers is, for example, as follows: punching a hole in one functional layer, and providing a screw holder of a predetermined height on the other functional layer, so that the fixation between the two functional layers can be realized by passing a screw through the hole in the functional layers and locking it to the screw holder, and a spacing of a predetermined height is retained between the two functional layers for mounting the signal processing units 30.

The plurality of functional layers includes a probe layer 11 and M data processing layers 12 sequentially stacked from bottom to top; a plurality of probes 20 are provided on a surface of the probe layer 11 away from the data processing layer 12, i.e., a plurality of probes 20 are provided on a lower surface of the probe layer 11, and a plurality of signal processing units 30 are provided on the data processing layers 12 respectively, and M is an integer greater than or equal to 1. Wherein, the functional layer in the probe device may be a support sheet that is micro-/nano-processed and has a certain mechanical strength, and the functional layer may be any one of the following: a silicon wafer, a glass wafer, a quartz wafer, a wafer, or a printed circuit board. It is to be noted that on each data processing layer 12, the signal processing unit 30 may be provided on the upper surface or the lower surface of the data processing layer 12, or may be provided on the upper and lower surfaces of the data processing layer 12, respectively, and this embodiment as well as subsequent embodiments are illustrated with the example that the signal processing unit 30 may be provided on the upper surface of the data processing layer 12.

Each signal processing unit 30 on the first data processing layer 12 corresponds to at least one probe 20, and each probe 20 corresponds to and is electrically connected to one signal processing unit 30 disposed on the first data processing layer 12. That is, in the probe device, each signal processing 30 in the data processing layer 12 (the first data processing layer 12) adjacent to the probe layer 11 corresponds to at least one probe 20 in the probe layer 11, and each probe 20 in the probe layer 11 only corresponds to one signal processing unit 30 in the first data processing layer 12, and the probes 20 are electrically connected to the corresponding signal processing units 30, respectively.

The signal processing unit 30 on the Nth data processing layer 12 of the M data processing layers 12 corresponds to at least one signal processing unit 30 on the N-1th data processing layer 12, and the signal processing unit 30 on the Nth data processing layer 12 corresponds to and is electrically connected to one signal processing unit 30 on the N+1th data processing layer 12, wherein 1≤N≤M, and N is an integer.

As can be seen from the above, the plurality of signal processing units 30 in the probe device are arranged on M data processing layers 12 respectively, and when M=1, as shown in FIGS. 8 and 9, the probe device forms a two-layer structure, i.e., comprising a data processing layer 12 for providing the plurality of signal processing units 30; and a probe layer 11 for providing the plurality of probes 20.

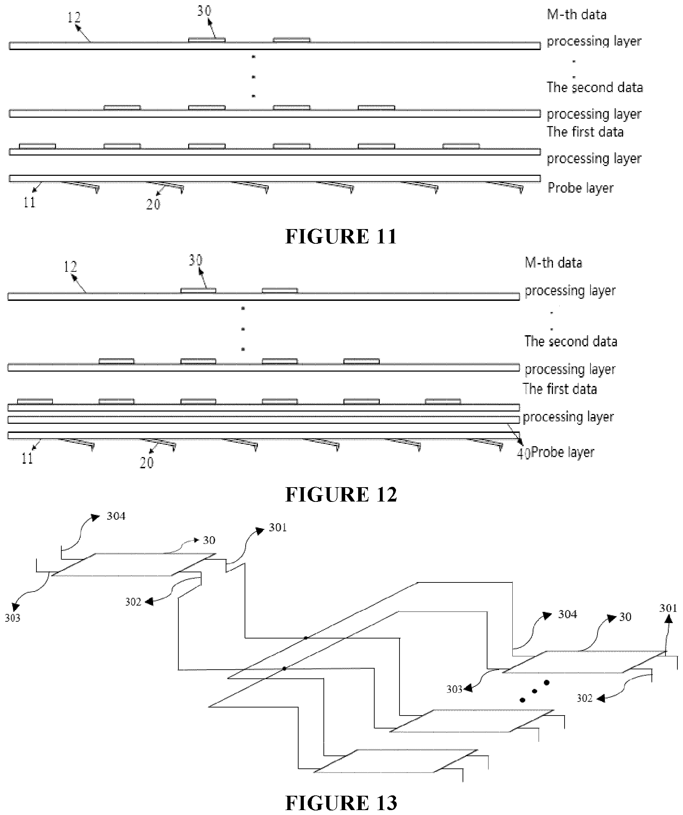

When M>1, as shown in FIGS. 10 and 11, the probe device forms a multilayer structure comprising: one probe layer 11 and M data processing layers 12 stacked sequentially from bottom to top; a plurality of probes 20 are provided on the probe layer 11, and a plurality of signal processing units 30 are provided on the data processing layers 12, respectively.

Wherein the number of signal processing units 30 arranged on each data processing layer 12 is greater than or equal to the number of signal processing units 30 arranged on the next adjacent data processing layer 12, thus forming a multilevel signal processing structure in which the number of signal processing units 30 increases sequentially from the top to the bottom, and taking the Nth data processing layer 12 of the M data processing layers 12 other than the first data processing layer 12 as an example, each signal processing unit 30 on the Nth data processing layer 12 corresponds to one or more signal processing units 30 on the N-1th data processing layer 12, and each signal processing unit 30 on the Nth data processing layer 12 only corresponds to one signal processing unit 30 on the N+1th data processing layer 12, and each signal processing unit 30 on the Nth data processing layer 12 is electrically connected to the signal processing unit 30 on the corresponding N+1th data processing layer 12, while each signal processing unit 30 on the Nth data processing layer 12 is electrically connected to the signal processing units 30 on the corresponding N-1th data processing layer 12, respectively.

The probe device is used to receive control parameters input by a user via the signal processing unit 30 on at least one data processing layer 12 and generate probe control signals of the probes. Specifically, in the M data processing layers 12 stacked from bottom to top, the signal processing units 30 on any one or more data processing layers 12 may all be connected to the probe control system, the probe control system is used for inputting the control parameters and sending the input control parameters to the signal processing units 30 on the connected data processing layers 12, and the signal processing units 30 generates probe control signals of the corresponding probes 20 upon receiving the control parameters.

The probe device is used to send the probe control signals to the corresponding probes 20 via the signal processing units 30 on the first data processing layer 12. Specifically, in the probe device, the correspondence with the probes 20 is preset in the signal processing units 30, whereby the signal processing units 30 may only receive and process the probe control signals of the corresponding probes 20. Taking the probe control signals only generating on the M-th data processing layer 12 as an example, on the M-th data processing layer 12, after generating the probe control signals of the corresponding probes 20, each signal processing unit 30 sends the generated probe control signals to the corresponding signal processing units 30 on the next data processing layer 12, respectively, after each signal processing unit 30 on the second data processing layer 12 receives the probe control signals of the corresponding probes 20, then send the probe control signals to the corresponding signal processing unit 30 on the next data processing layer 12, and so on, until the probe control signals are sent to the corresponding signal processing unit 30 on the first data processing layer 12, and then the probe control signals are sent to the corresponding probes 20 by the signal processing unit 30 on the first data processing layer 12 to control the electrically connected probes 20 to perform corresponding processing on the surface of the wafer to be operated.

The probe 20 is used to operate and process the surface to be operated based on the received probe control signals and send the obtained probe data signals to the corresponding signal processing unit 30. Specifically, for each probe 20, its operating parameters, such as operating mode, operating range, etc., are set in the received probe control signals sent by the corresponding signal processing unit 30, the probe 20 may operate and process the surface to be operated based on the probe control signals to obtain the probe data signals, and send the probe data signals to the corresponding signal processing unit 30 on the first data processing layer 12, and then the probe data signals are digitized, decoded, and processed, and so on by the signal processing unit 30 on the M data processing layer 12 to obtain data of pixels of the surface of the wafer to be operated, and the data of pixels are sent to the probe control system, and a complete image of the surface of the wafer to be operated is generated by the probe control system. Wherein, the probe data signals of the probes 20 include, but are not limited to: a longitudinal force signal of the probe, a spatial probe position signal, speed data of the probe, vibration frequency data of the probe, temperature data of the probe, code or address data of the probe, and the like.

In the present embodiment, a three-dimensional structured probe device comprising a signal processing unit and a probe is provided, thus reducing the connecting lines between the signal processing unit and the probe; when the number of probes is large, the connecting lines required for externally connecting the probe device can be reduced by setting up a multilevel data processing layer used to set up the signal processing unit, which facilitates the connection between the probe device and an external probe control system. Meanwhile, the probe and the signal processing unit are integrated into different functional layers, which reduces the influence of the heat emitted by the signal processing unit on the probe and reduces the loss of precision.

In one example, M ^ 2, upon receiving the probe data signals sent by the corresponding probes 20, the signal processing unit on the first data processing layer 12 sends the probe data signals to the signal processing unit 30 on the M-th data processing layer 12; after receiving the probe data signals from the respective probes 20, the signal processing unit 30 on the M-th data processing layer 12 processes the probe data signal to obtain a data processing result of the surface to be operated. That is, a plurality of data processing layers 12 are provided in the probe device, and upon receiving the probe data signals sent by the corresponding probes 20, the signal processing unit 30 on the lowermost data processing layer 12 sends the probe data signals of the probes 20 via the signal processing unit 30 on the data processing layer 12 adjacent to the M-th data processing layer 12 to the signal processing unit 30 on the M-th data processing layer 12, and the signal processing unit 30 on the M-th data processing layer 12 processes the probe data signals of the corresponding probes 20, the processing including digitizing, decoding, and other operations, and then sends the obtained data of pixels of the surface of the wafer to be operated to the probe control system, and a complete image of the surface of the wafer to be operated is generated by the probe control system.

Wherein, the probe data signals of the probes 20 are stored in the corresponding signal processing units 30 on the first data processing layer 12, or in the corresponding signal processing units 30 on the M-th data processing layer 12.

That is, the raw probe data signals collected by the probes 20 on the probe layer 11 may be stored in the corresponding signal processing unit 30 on the adjacent data processing layer 12, and the processing of the probe data signals is carried out by the signal processing unit 30 on the topmost data processing layer 12 (the M-th data processing layer 12), at this time, it is possible to connect the topmost data processing layer 12 (the M-th data processing layer 12) to the probe control system by means of a connection wire only, and with the processing of the probe data signals with a large amount of arithmetic being placed on the topmost data processing layer 12, there exists at least one data processing layer 12 between the topmost data processing layer 12 and the probe layer 11, which further reduces the influence of the heat emitted by the signal processing unit 30 on the probes 20 on the probe layer 11. Alternatively, the raw probe data signals collected by the probes 20 on the probe layer 11 are stored in the signal processing unit 30 on the topmost data processing layer 12 (the M-th data processing layer 12), and it is more convenient to set up a memory on the topmost data processing layer 12, which reduces the difficulty of arranging the memory.

In one example, M≥2, the signal processing unit 30 on the first data processing layer of the M data processing layers 12 processes the probe data signals of the corresponding probes 20 upon receiving the probe data signals sent by the corresponding probes 20, obtains the data processing results of the corresponding probes, and sends the data processing results of the probes 20 to the signal processing unit 30 on the M-th data processing layer 12; the signal processing unit 30 on the M-th data processing layer 12 obtains the data processing results of the surface to be operated based on the data processing results of the probes 20 upon receiving the data processing results of the surface to be operated. That is, the first data processing layer 12 of the M data processing layers 12 processes the received probe data signals of the probes 20 to obtain the data processing results of the respective probes 20 upon receiving the raw probe data signals collected by the corresponding probes 20, and only sends the data processing results of the corresponding probes 20 to the data processing unit 30 on the topmost data processing layer 12 (the M-th data processing layer 12), and the signal processing unit 30 on the topmost data processing layer 12 (the M-th data processing layer 12) sends the data processing results of the probes 20 to the probe control system, so that the data processing layer 12 on the topmost data processing layer only needs to store the processed data processing results of the probes 20, thereby reducing the data storage requirements for the signal processing unit 30 on the topmost data processing layer 12.

In one example, a heat dissipation layer is provided between two adjacent functional layers, i.e., the heat dissipation layer may be made of a material with a faster heat dissipation rate to reduce the exchange of heat between the functional layers, furthermore, the heat dissipation layer may be a semiconductor refrigeration layer, and the semiconductor refrigeration layer may be cooled after being energized, so as to be able to actively dissipate heat and further reduce the temperature of the probe device, so as to further reduce the influence of heat emitted by a signal processing unit on the probe; furthermore, the semiconductor refrigeration layer does not require a refrigerant and operates without vibration and noise, thereby not affecting the probes. Wherein, the heat dissipation layer is at least provided between a first data processing layer 12 of the M data processing layers 12 and the probe layer 11, i.e., the heat dissipation layer is provided between the probe layer 11 and the adjacent data processing layer 12, and the heat dissipation layer may or may not be provided between the probe layer 11 and the adjacent data processing layers 12. As shown in FIG. 12, a schematic diagram is shown in which the heat dissipation layer 40 is provided only between the probe layer 11 and the adjacent data processing layer 12.

In one example, referring to FIG. 3, the probes 20 include: a needle 201, a cantilever beam 202, and a needle tip 203, and in each of the probes 20, the needle tip 203 is provided at a tip portion of the needle 201, and the needle 201 is fixed to an end of the cantilever beam 202, and the end of the cantilever beam 202 that is away from the needle 201 includes: a control input terminal 204 and a signal output terminal 205.

The signal processing unit 30 includes a control output terminal 301, a signal input terminal 302, a signal sending terminal 303, and a signal receiving terminal 304; the control input terminal 204 of the cantilever beam 202 of the probe 20 is connected to the control output terminal 301 of the corresponding signal processing unit 30 in the first data processing layer 12 (i.e., the data processing layer 12 adjacent to the probe layer 11), and a signal output terminal 205 of the cantilever beam 202 of the probe 20 is connected to a signal input terminal 302 of the corresponding signal processing unit 30 in the first data processing layer 12.

In the Nth data processing layer 12 of the M data processing layers 12, the signal transmitting terminal 303 of the signal processing unit 30 is connected to the signal input terminal 302 of the corresponding signal processing unit 30 in the N+1th data processing layer 12, and the signal receiving terminal 304 of the signal processing unit 30 is connected to the control output terminal 301 of the corresponding signal processing unit 30 in the N+1th data processing layer 12.

The probe 20 is used to control the probe tip 203 to operate and process the surface to be operated according to the probe control signal received from the control input terminal, and to send the probe data signals obtained to the signal input 302 of the connected signal processing unit 30.

The signal processing unit 30 is used to send the received probe data signals to a corresponding signal processing unit 30 in a target functional layer; the target functional layer is the data processing layer 12 previous to the data processing layer 12 in which the signal processing unit is located.

Specifically, in the probe device, the signal transmitting terminals 303 and the signal receiving terminals 304 of the signal processing units 30 on the M-th data processing layer 12 are respectively connected to the probe control system, and the signal processing unit 30 receives control parameters from the probe control system via the signal receiving terminal 304, and generates probe control signals of the corresponding probes 20 based on the control parameters; additionally, the signal processing unit 30 may also be provided with an operation information receiving terminal, which is connected to the probe control system, and the probe control system sends the operation parameters of the operation station where the probe device is located to the signal processing unit 30 via the operation information receiving terminal, so that the signal processing unit 30 may determine position, angle, speed, and other information of the wafer based on the operation parameters, and then generate the probe control signals of the probes 20 in combination with the control parameters input by the user.

After the signal processing units 30 on the data processing layer 12 generate the probe control signals of the probes 20, the probe control signals are sent to the corresponding probes 20 via the signal processing unit 30 on the data processing layers 12 of the M-level, and after receiving the corresponding probe control signals via the control input terminal 204, the probe 20 controls the probe tip 203 to operate and process the surface to be operated based on the probe control signal process, and operate and process the surface to be operated based on the operating parameters of the probe 20 set in the probe control signals, obtain the probe data signals, and send the probe data signals to the corresponding signal processing unit 30 on the adjacent data processing layer 12, the probe data signals are digitized, decoded and processed and so on by the signal processing unit 30 on the adjacent data processing layer 12 to obtain the data of pixels of the surface of wafer to be operated, and the data of pixels is sent to the probe control system, then a complete image of the surface of the wafer to be operated is generated by the probe control system.

It should be noted that if one signal processing unit 30 on the Nth data processing layer 12 corresponds to a plurality of signal processing units 30 on the N-1th data processing layer 12, then one signal processing unit 30 on the Nth data processing layer 12 may be connected to the corresponding plurality of signal processing units 30 on the N-1th data processing layer 12 via a bus, refer to FIG. 13. Similarly, if one signal processing unit 30 on the first data processing layer 12 corresponds to a plurality of probes 20 on the probe layer 11, then one signal processing unit 30 on the first data processing layer 12 may be connected to the corresponding plurality of probes 20 on the probe layer 11 via a bus, refer to FIG. 4, and will not be repeated here.

In one example, a plurality of positioning marks are provided on the probe layer, a plurality of positioning holes are provided on each data processing layer, the positioning holes correspond one-to-one with the positioning marks, and the positions of the positioning holes on each data processing layer and those of the corresponding positioning marks on the probe layer correspond in vertical space, whereby the positioning holes may be optically aligned with the positioning marks during the working of the probe device, so as to realize the alignment between the data processing layers and the probe layer, whereby enable a stable electrical connection between adjacent data processing layers and between the data processing layers and the probe layer be maintained.

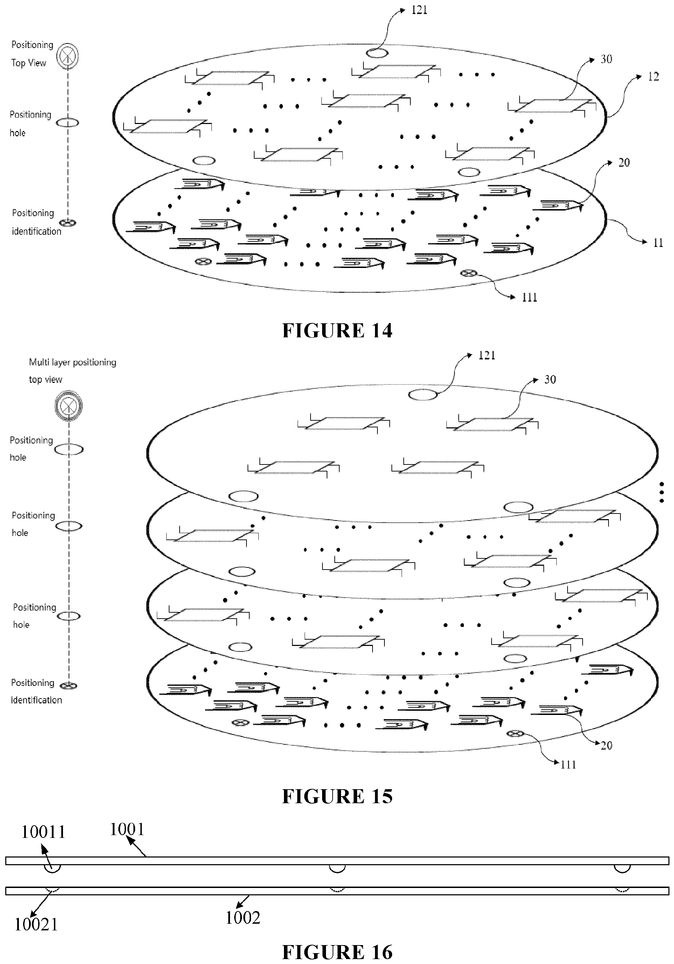

Referring to FIG. 14, M=1, i.e., the probe device forms a two-layer structure, i.e., comprising a data processing layer 12 and a probe layer 11, at this time three positioning marks 111 are provided on the probe layer 11, and three positioning holes 121 are provided on the data processing layer 12, the positioning holes 121 correspond one-to-one with the positioning marks 111, and the positions of the positioning holes 121 and those of the corresponding positioning marks 111 correspond in vertical space; the size of the positioning holes 121 on the data processing layer 12 is larger than that of the positioning marks 111 on the probe layer 11, so that the vertical space alignment of the probe layer 11 and the data processing layer 12 may be achieved by aligning the positioning holes 121 with the corresponding positioning marks 111 in vertical space, refer to the positioning top view in FIG. 14, so that the data processing units 30 on the data processing layer 12 are able to be vertically spatially aligned and electrically connected with the corresponding probes 20 on the probe layer 11; wherein the positioning mark 111 can be, for example, a cross mark (this is taken as an example in FIG. 14), a triangular mark, and the like.

Referring to FIG. 15, M > 1, i.e., the probe device forms a multilayer structure including: a probe layer 11 and M data processing layers 12 sequentially stacked from bottom to top; at this time, three positioning marks 111 are provided on the probe layer 11, and three positioning holes 121 are provided on each of the data processing layers 12, and the positioning holes 121 on each data processing layer 12 correspond one-to-one to the positioning marks 111 on the probe layer 11, and on each data processing layers 12, the positions of the positioning holes 121 and those of the corresponding positioning marks 111 correspond in the vertical space. The size of the positioning holes 121 on the first data processing layer 12 is larger than that of the positioning mark 111 on the probe layer 11, and the diameters of the positioning holes 121 on the M data processing layers 12 increase sequentially from bottom to top, thereby enabling the positioning holes 121 on the M data processing layers 12 to be aligned in the vertical space with the corresponding positioning mark 111 on the probe layer 11, see a positioning top view in FIG. 15, i.e., the M data processing layers 12 and the probe layer 11 are aligned in vertical space; whereby between two adjacent data processing layers 12, the data processing units 30 on the data processing layer 12 of the upper layer are able to be aligned in vertical space and electrically connected with the corresponding data processing unit 30 on the data processing layer 12 of the lower layer, and between the first data processing layer 12 and the probe layer 11, the data processing units 30 on the data processing layer 12 are able to be aligned in vertical space and electrically connected with the corresponding probes 20 on the probe layer 11; in summary, the alignment in vertical space and electrical connection between the functional layers are realized; wherein the positioning mark 111 may be, for example, a cross mark (this is taken as an example in FIG. 15), a triangular mark, and the like.

In one example, a plurality of pairs of matched raised portions and recessed portions are provided on opposite surfaces between two adjacent functional layers; the positions of each pair of matched raised portions and recessed portions correspond in vertical space, whereby after the matched raised portions and recessed portions between the two adjacent functional layers are installed correspondingly, the two functional layers are able to be secured without the need to additionally provide a securing device for securing the two functional layers, and a certain interval is formed between the two functional layers for the installation of various components; wherein the two adjacent functional layers include a probe layer and a first data processing layer, and two adjacent data processing layers, i.e., a plurality of pairs of matched raised portions and recessed portions are respectively provided on opposite surfaces between the probe layer and the first data processing layer, and a plurality of pairs of matched raised portions and recessed portions are respectively provided on opposite surfaces between the two adjacent data processing layers, and the plurality of raised portions and recessed portions may be set in a layout on the faces where they are located based on the stability of the installation between the functional layers. In addition, the shapes of each pair of matched raised and recessed portions may be set according to the requirements, for example, if the recessed portion is a spherical depression and the raised portion is a spherical projection, and the end of the spherical projection that is in contact with the spherical recessed portion is a sphere that is matched in size to the shape of the spherical depression, so that the spherical raised portion is partially embedded in the spherical recessed portion when the spherical raised portion is mounted to the spherical recessed portion. For example, if the recessed portion is a cone-shaped depression, the shape of the raised portion is a cone-shaped projection that matches the shape of that cone-shaped depression.

It is noted that each pair of the matched raised portions and recessed portions is respectively provided on the opposite surfaces between two adjacent functional layers, and in the case of any two adjacent functional layers, for example, the raised portions may be provided on the upper surface of the lower functional layer and the recessed portions may be provided on the lower surface of the upper functional layer; or the recessed portions may be provided on the upper surface of the lower functional layer and the raised portions may be provided on the lower surface of the upper functional layer; the following is an example that the recessed portions are provided on the upper surface of the lower functional layer and the raised portions are provided on the lower surface of the upper functional layer.

Referring to FIG. 16, two adjacent functional layers (components on the functional layers are not shown in the figure) are referred as a first functional layer 1001 and a second functional layer 1002, three recessed portions 10021 are provided on an upper surface of the first functional layer 1001, and three raised portions 10011 are provided on a lower surface of the second functional layer 1002, the three raised portions 10011 and the three recessed portions 10021 correspond one-to-one and match in shape and size, and the positions of each pair of matched raised portions 10011 and recessed portions 10021 correspond in vertical space, whereby the positioning and fixing between the first functional layer 1001 and the second functional layer 1002 can be realized by mounting the matched raise portions 10011 and the recessed portions 10021 together.

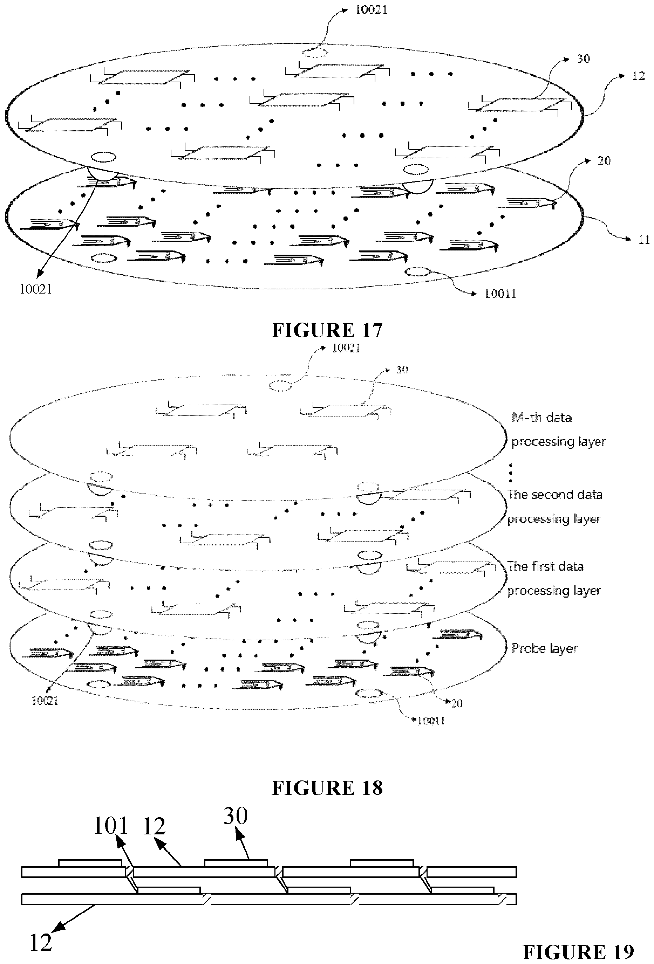

Referring to FIG. 17, M=1, i.e., the probe device forms a two-layer structure, i.e., comprising a data processing layer 12 and a probe layer 11, at this time three recessed portions 10021 are provided on the upper surface of the probe layer 11, and three raised portions 10011 are provided on the lower surface of the data processing layer 12, the three raised portions 10011 and the three recessed portions 10021correspond one-to-one and match in shape and size, the positions of each pair of matched raised portions 10011 and recessed portions 10021 correspond in vertical space, and the positioning and fixing between the probe layer 11 and the data processing layer 12 can be realized by mounting the pairs of matched raised portions 10011 and the recessed portions 10021 together respectively, whereby the data processing units 30 on the data processing layer 12 are able to be aligned in vertical space and electrically connected with the corresponding probes 20 on the probe layer 11.

Referring to FIG. 18, M > 1, i.e., the probe device forms a multilayer structure comprising: a probe layer 11 and M data processing layers 12 sequentially stacked from bottom to top; at this time, between the probe layer 11 and the first data processing layer 12, three recessed portions 10021 are provided on the upper surface of the probe layer 11, and three raised portions 10011 are provided on the lower surface of the data processing layer 12, the three raised portions 10011 and the three recessed portions 10021 correspond one to one and match in shape and size, and the positions of each pair of matched raised portions 10011 and recessed portions 10021 correspond in vertical space, and the positioning and fixing between the probe layer 11 and the first data processing layer 12 can be realized by mounting the pairs of matched raised portions 10011 and recessed portions 10021 together respectively, whereby the data processing units 30 on the first data processing layer 12 are able to be aligned in vertical space and electrically connected with the corresponding probes 20 on the probe layer 11.

Between two adjacent data processing layers 12, three recessed portions 10021 are provided on the upper surface of the lower data processing layer 12, and three raised portions 10011 are provided on the lower surface of the upper data processing layer 12, the three raised portions 10011 and the three recessed portions 10021 correspond one-to-one and match in shape and size, and the positions of each pair of matched raised portions 10011 and recessed portions 10021correspond in vertical space, so that positioning and fixing between two adjacent data processing layers 12 can be realized by mounting the pairs of matched raised portions 10011 and recessed portions 10021 together respectively, whereby the data processing units 30 on the upper data processing layer 12 are able to be aligned in vertical space and electrically connected with the corresponding data processing units 30 on the lower data processing layer 12.

It should be noted that FIG. 18 is an example of aligning the positions of the raised portion 10011 and the recessed portion 10021 in vertical space on all the functional layers (including the probe layer 11 and the data processing layer 12), but it is not limited to this, and it is possible to set the positions of the pairs of matched raised portion 10011 and recessed portion 10021 in vertical space in the case of ensuring that each pair of matched raised portions 10011 and the recessed portions 10021 are aligned in the vertical space.

In one embodiment, each data processing layer is provided with a plurality of through-holes, which are provided with insulating layers on the inner walls, and the through-holes are provided with conductive substances, and on each data processing layer, each signal processing unit corresponds to at least one through-hole, and each through-hole corresponds to one signal processing unit; when 1≤N <M, for each signal processing unit on the Nth data processing layer of M data processing layers, the signal processing unit is electrically connected to a target signal processing unit in the N+1th data processing layer through the conductive substances in the corresponding through-holes; the target signal processing unit is a signal processing unit corresponding to the signal processing unit on the N+1th data processing layer; when N=M, for each signal processing unit on the Nth data processing layer of the M data processing layers, the signal processing unit is electrically connected to is electrically connected to a target probe on the probe layer through the conductive substances in the corresponding through-holes; the target probe is a probe corresponding to the signal processing unit. That is, the present embodiment provides a way of electrically connecting between two adjacent functional layers, referring to FIG. 19, between two adjacent data processing layers 12, a plurality of through-holes 101 are provided on the upper data processing layer 12, an insulating layer is provided on the inner wall of the through-hole 101, and conductive substances (e.g., copper, silver, or other conductive materials) are provided in the through-holes 101, and each signal processing unit 30 corresponds to at least one through-hole 101, each through-hole 101 corresponding to one signal processing unit 30; each signal processing unit 30 on the upper data processing layer 12 corresponds to at least one signal processing unit 30 on the lower data processing layer 12, and each signal processing unit 30 on the lower data processing layer 12 only corresponds to one signal processing unit 30 on the data upper processing layer 12; the through-holes 101 are filled with a conductive material, which is equivalent to forming a conductive channel in the through-hole 101, the conductive channel forms an electrical connection between the two surfaces of the data processing layer 12, and two conductive contact points are formed on the two surfaces of the data processing layer 12, taking one signal processing unit 30 on the upper data processing layer 12 as an example, the signal processing unit 30 may be electrically connected by a wiring or directly welded to the conductive contact point on the upper surface, and the corresponding signal processing unit 30 on the data processing layer 12 of the lower layer may be welded to the electrically conductive weld points formed by the corresponding through-holes 101 on the lower surface of the upper data processing layer 12 by the conductive leads, thereby realizing an electrical connection between the corresponding signal processing units 30 on the two data processing layers 12. Between the data processing layer 12 and the probe layer 11, the signal processing unit 30 is electrically connected to the corresponding probe 20 in a manner similar to that described above and will not be repeated herein.

In another embodiment, the functional layer is provided with a plurality of through-holes, which are provided with insulating layers on the inner walls, and on each data processing layer, each signal processing unit corresponds to at least one through-hole, and each through-holes corresponds to one signal processing unit; when 1≤N<M, for each signal processing unit on the Nth data processing layer of M data processing layers, the signal processing unit is electrically connected to a target signal processing unit in the N+1th data processing layer by means of leads passing through the corresponding through-holes; the target signal processing unit is the signal processing unit corresponding to the signal processing unit on the Nth data processing layer; when N = 1, for each signal processing unit on the Nth data processing layer of the M data processing layers, the signal processing unit is electrically connected to a target probe on the probe layer ty means of leads passing through the corresponding through-hole; the target probe is a probe corresponding to the signal processing unit. That is, the present embodiment provides an electrical connection between two adjacent functional layers, between two adjacent data processing layers 12, a plurality of through-holes 101 are provided on the upper data processing layer 12 and an insulating layer is provided on the inner wall of the through-hole 101, and each signal processing unit 30 corresponds to at least one through-hole 101, and each through-hole 101 corresponds to one signal processing units 30; each signal processing unit 30 on the upper data processing layer 12 corresponds to at least one signal processing unit 30 on the lower data processing layer 12 , and each signal processing unit 30 on the lower data processing layer 12 only corresponds to one signal processing unit 30 on the upper data processing layer 12; taking one signal processing unit 30 on the upper data processing layer 12 as an example, the signal processing unit 30 may be connected to the signal processing unit 30 by a conductive lead passing through the corresponding through-hole 101, the conductive lead is directly connected to the corresponding signal processing unit 30 on the lower data processing layer 12 thereby realizing an electrical connection between the corresponding signal processing units 30 on the two data processing layers 12. Between the probe layer 11 and the data processing layer 12, the signal processing unit 30 is electrically connected to the corresponding probe 20 in a manner similar to that described above and will not be repeated herein.

In one embodiment, each probe has a corresponding address, and any two probes correspond to different addresses; please refer to FIG. 7, a plurality of probes 20 are provided in the probe layer 11, and the address of each probe 20 is expressed in the coordinates of the location where it is located, for example, the addresses of nine probes 20 in the first column are from the bottom to the top: (X1, Y4), (X1, Y5), (X1, Y6), (X1. Y7), (X1, Y8), (X1, Y9), (X1, Y10), (X1, Y11), (X1, Y12); wherein the value of X, Y in the address of each probe 20 may be one or more bytes, whereby the probes 20 may be identified separately. It should be noted that the way in which the probes 20 are laid out on the probe layer 11 is given schematically only in FIG. 7.

A third embodiment of the present application relates to a probe control apparatus comprising a probe device in the first embodiment or the second embodiment and a probe control system connected to the probe device, the probe control system is, for example, a computer mainframe, a laptop, and the like.

Preferred embodiments of the present application have been described in detail above, but it should be understood that aspects of the embodiments can be modified to employ aspects, features and ideas from various patents, applications and publications to provide additional embodiments, if desired.

These and other variations to the embodiments can be made in view of the detailed description above. In general, in the claims, the terms used should not be considered as limiting the specific embodiments disclosed in the specification and claims but should be understood to include all possible embodiments together with the full scope of equivalents enjoyed by those claims.

## Claims

1. A probe device wherein it comprises: a functional layer, a plurality of probes, and at least one signal processing unit;
said plurality of probes are provided on one surface of said functional layer and said at least one signal processing unit is provided on the other surface of said functional layer; each said signal processing unit corresponds to at least one said probe, and each said probe corresponds to and is electrically connected to one said signal processing unit;
said signal processing unit is used to generate a probe control signal according to control parameters input by a user and send said probe control signal to the corresponding probe;
said probe is used to operate and process the surface to be operated according to said probe control signal received, and to send probe data signals obtained to the corresponding signal processing unit.

2. The probe device according to claim 1, **characterized in that** said functional layer is provided with a plurality of through-holes therein, which are provided with insulating layers on inner walls thereof, said through-holes are provided with conductive substances therein, each said signal processing unit corresponds to at least one said through-hole, and each said through-hole corresponds to one said signal processing unit; said signal processing unit is electrically connected to a target probe through the conductive substances in the corresponding through-holes; said target probe is said probe corresponding to said signal processing unit.

3. The probe device according to claim 1, **characterized in that** said functional layer is provided with a plurality of through-holes therein, which are provided with insulating layers on inner walls thereof, each said signal processing unit corresponds to at least one said through-hole, and each said through-hole corresponds to one said signal processing unit; said signal processing unit is electrically connected to a target probe by means of leads passing through the corresponding through-holes, and said target probe is said probe corresponding to said signal processing unit.

4. The probe device according to claim 1, **characterized in that** said probe comprises: a needle, a cantilever beam and a needle tip, and in each said probe, said needle tip is provided at the tip portion of said needle, said needle is fixed at one end of said cantilever beam, and said cantilever beam, which is at the end away from said needle, comprises: a control input terminal and a signal output terminal; said signal processing unit comprising a control output terminal and a signal input terminal, said control input terminal of said cantilever beam is connected to the control output terminal of the corresponding signal processing unit, said signal output terminal of said cantilever beam is connected to the signal input terminal of the corresponding signal processing unit;
said probe is used to control said needle tip to operate and process the surface to be operated according to said probe control signal received from said control input, and to send the obtained probe data signal to the signal input terminal of said signal processing unit connected thereto.

5. The probe device according to any one of claims 1 to 4, **characterized in that** said functional layer is any one of the following: a silicon wafer, a glass wafer, a quartz wafer, a wafer or a printed circuit board.

6. The probe device according to claim 1, **characterized in that** each said probe has a corresponding address and any two said probes correspond to different addresses, respectively.

7. A probe device wherein it comprises: a plurality of functional layers fixed in a non-contact manner, a plurality of probes, and a plurality of signal processing units; said plurality of functional layers comprise one probe layer and M data processing layers stacked sequentially from bottom to top; said plurality of probes are provided on a surface of said probe layer away from said data processing layers, and said plurality of signal processing units are provided on said data processing layers, respectively, and M is an integer greater than or equal to 1;
each said signal processing unit on a first said data processing layer corresponds to at least one said probe, and each said probe corresponds to and is electrically connected to one said signal processing unit located on the first said data processing layer;
said signal processing unit on the Nth said data processing layer of M said data processing layers corresponds to at least one said signal processing unit on the N-1th said data processing layer, and said signal processing unit on the Nth said data processing layer corresponds to and is electrically connected to one said signal processing unit on a N+1th said data processing layer, **characterized in that** 1≤N≤ M, and N is an integer;
said probe device is used to receive input control parameters through said signal processing unit on at least one said data processing layer and generate probe control signals for said probes;
said probe device is used to send said probe control signals to the corresponding probes via said signal processing unit on a first said data processing layer;
said probe is used to operate and process a surface to be operated according to said probe control signals received, and to send probe data signals obtained to the corresponding signal processing unit.

8. The probe device according to claim 7, **characterized in that** M≥2, said signal processing unit on the first said data processing layer sends said probe data signals to the signal processing unit on a M-th said data processing layer upon receiving the probe data signals sent by the corresponding probes;
after receiving said probe data signals from said probes, said signal processing unit on the M-th said data processing layer processes said probe data signals to obtain a data processing result of the surface to be operated.

9. The probe device according to claim 7, **characterized in that** MN2, upon receiving a probe data signal sent by a corresponding said probe, said signal processing unit on the first said data processing layer of M said data processing layers processes the probe data signals of the corresponding probes, obtains data processing results of the corresponding probes and sends said data processing results of said probes to the signal processing unit on a M-th said data processing layer;
said signal processing unit on the M-th said data processing layer obtains a data processing result of the surface to be operated based on the data processing results of said probes upon receiving the data processing results of said probes.

10. The probe device according to claim 8, **characterized in that** the probe data signals of said probes are stored in the corresponding signal processing unit on the first said data processing layer, or stored in the corresponding signal processing unit on the M-th said data processing layer.

11. The probe device according to claim 7, **characterized in that** a heat dissipation layer is provided between two adjacent said functional layers.

12. The probe device according to claim 11, **characterized in that** said heat dissipation layer is a semiconductor refrigeration layer.

13. The probe device according to claim 7, **characterized in that** each said data processing layer is provided with a plurality of through-holes therein, which are provided with insulating layers on inner walls thereof, and said through-holes are provided with conductive substances therein, and on each said data processing layer each said signal processing unit corresponds to at least one said through-hole, and each said through-hole corresponds to one said signal processing unit;
when 1≤N<M, for each said signal processing unit on a Nth said data processing layer of the M said data processing layers, said signal processing unit is electrically connected to a target signal processing unit in the N+1th said data processing layer by means of conductive materials in the corresponding through-holes; said target signal processing unit is a signal processing unit corresponding to said signal processing unit on a N+1th said data processing layer;
When N=1, for each said signal processing unit on the first said data processing layer of the M said data processing layers, said signal processing unit is electrically connected to a target probe on said probe layer by means of the conductive substances in the corresponding through-holes; said target probe is said probe corresponding to said signal processing unit.

14. The probe device according to claim 7, **characterized in that** said functional layer is provided with a plurality of through-holes therein, which are provided with insulating layers on inner walls thereof, and on each said data processing layer, each said signal processing unit corresponds to at least one said through-hole, and each said through-hole corresponds to one said signal processing unit;
when 1≤N<M, for each said signal processing unit on a Nth said data processing layer of the M said data processing layers, said signal processing unit is electrically connected to a target signal processing unit in a N+1th said data processing layer by means of leads passing through the corresponding through-holes; said target signal processing unit is a signal processing unit on the N+1th said data processing layer corresponding to said signal processing unit;
When N=1, for each said signal processing unit on the first said data processing layer of the M said data processing layers, said signal processing unit is electrically connected to a target probe on said probe layer by means of leads passing through the corresponding through-holes; said target probe is said probe corresponding to said signal processing unit.

15. The probe device according to claim 7, **characterized in that** said probe layer is provided with a plurality of positioning marks, and each said data processing layer is provided with a plurality of positioning holes, said positioning holes are corresponding one-to-one with said positioning marks, and positions of said positioning holes on each said data processing layer and those of the corresponding positioning marks on said probe layer correspond in vertical space.

16. The probe device according to claim 7, **characterized in that** a plurality of pairs of matched raised portions and recessed portions are provided on opposite faces between two adjacent functional layers, respectively; positions of each pair of matched said raised portions and said recessed portions correspond in vertical space.

17. The probe device according to claim 7, **characterized in that** said probe comprises: a needle, a cantilever beam and a needle tip, in each said probe said needle tip is provided at a tip portion of said needle, said needle is fixed to one end of said cantilever beam, one end of said cantilever beam away from said needle comprising: a control input terminal and a signal output terminal; and each said signal processing unit comprises a signal receiving terminal, a signal transmitting terminal, a control output terminal and a signal input terminal, said control input terminal of said cantilever beam is connected to the control output terminal of the corresponding signal processing unit in a first said data processing layer, said signal output terminal of said cantilever beam is connected to the signal input terminal of the corresponding signal processing unit in a first said data processing layer;
in a Nth said data processing layer of M said data processing layers, the signal transmitting terminal of said signal processing unit is connected to the signal input terminal of the corresponding signal processing unit in a N+1th said data processing layer, and the signal receiving terminal of said signal processing unit is connected to the control output terminal of the corresponding said signal processing unit in the N+1th said data processing layer;
said probe is used to control said needle tip to operate and process the surface to be operated according to said probe control signal received from said control input terminal, and to send an obtained probe data signal to the signal input terminal of said signal processing unit connected thereto;
said signal processing unit is used to send the received probe data signal to the corresponding signal processing unit in a target functional layer; said target functional layer is said data processing layer previous to said data processing layer in which said signal processing unit is located.

18. The probe device according to any one of claims 7 to 17, **characterized in that** said functional layer is any one of the following: a silicon wafer, a glass wafer, a quartz wafer, a wafer or a printed circuit board.

19. The probe device according to claim 7, **characterized in that** each said probe has a corresponding address and any two said probes correspond to different addresses.

20. A probe control apparatus, wherein it comprises: a probe device according to any one of claims 1 to 19 and a probe control system connected to said probe device.
